# EUROPEAN PATENT SPECIFICATION

(11) **EP 4 528 593 B1**
(45) Date of publication and mention of the grant of the patent: **28.01.2026**
(21) Application number: 24191580.0
(22) Date of filing: 29.07.2024
(51) Int. Cl.: G06N 3/065, G06N 3/08, H10B 69/00

(54) **3-TERMINAL SYNAPSE DEVICE FOR ARTIFICIAL NEURAL NETWORK LEARNING, SYNAPSE ARRAY USING THE SAME AND ITS OPERATION METHOD**
3-TERMINALE SYNAPSENVORRICHTUNG ZUM LERNEN KÜNSTLICHER NEURONALER NETZE, SYNAPSENANORDNUNG DAMIT UND BETRIEBSVERFAHREN DAFÜR
DISPOSITIF DE SYNAPSES À 3 TERMINAUX POUR APPRENTISSAGE DE RÉSEAU NEURONAL ARTIFICIEL, RÉSEAU DE SYNAPSES L'UTILISANT ET SON PROCÉDÉ DE FONCTIONNEMENT

(30) Priority: 22.09.2023 KR 20230126835
(43) Date of publication of application: 26.03.2025
(73) Proprietor: POSTECH Research and Business Development Foundation, Pohang-si, Gyeongsangbuk-do 37673 (KR)
(72) Inventor: KIM, Seyoung, 37664 Gyeongsangbuk-do (KR); LEE, Byoungwoo, Gyeongsangbuk-do (KR); SON, JeongHoon, Busan (KR); KIM, Seungkun, 35258 Daejeon (KR)
(74) Representative: Germain Maureau

(56) References cited:
- LI YIYANG ET AL: "In situ Parallel Training of Analog Neural Network Using Electrochemical Random-Access Memory", FRONTIERS IN NEUROSCIENCE, vol. 15, 8 April 2021 (2021-04-08), CH, pages 636127 - 1, XP093031035, ISSN: 1662-453X, DOI: 10.3389/fnins.2021.636127

## Description

### TECHNICAL FIELD

The present disclosure relates to synaptic device-based neuromorphic technology, and more specifically, to a technology for constructing a cross-point array based on a synaptic device with a three-terminal structure consisting of an electrochemical memory (ECRAM) and two transistors and for achieving an improvement in the accuracy of inference and learning operations performed by an artificial neural network through parallel operation.

This work was supported by the MOTIE (Ministry of Trade, Industry & Energy) (1415187361) and KSRC (Korea Semiconductor Research Consortium) (RS-2023-00236568) support program for the development of the future semiconductor device.

### BACKGROUND

Learning through an artificial neural network, which mimics the parallel computational processing of the brain, can perform inference and learning processes through vector matrix operations and external operations, and is expected to accelerate operations hundreds to thousands of times more than existing digital hardware. In particular, calculation acceleration can be achieved by using a hardware cross point array based on a resistance-variable synaptic device, and an operation method for a cross point based on a two-terminal analog synapse has been proposed.

The conventional driving method of the resistance-variable synapse-based cross-point array to accelerate the learning of artificial intelligence neural networks may be limited to synaptic devices with a two-terminal structure as a resistance-variable memory. In other words, this method may affect the stable operation of a three-terminal electrochemical memory-based cross-point array. Therefore, in order to use a non-volatile memory device with a three-terminal structure rather than a two-terminal structure as a synaptic device of a cross-point array, a new array structure and operation method may be needed to operate it.

Specifically, in order to perform artificial neural network learning using the resistance-variable synapse-based cross-point, it is necessary to employ a half-bias scheme to apply voltage pulses of half the driving voltage in opposite polarities in the gate and source directions of the cross-point so that synaptic devices in the cross-point array are updated when the pulses overlap.

However, this operation method may be applicable to a resistance-variable array with a two-terminal structure. That is, when the same method is applied to a resistance-variable array with a three-terminal structure, sufficient update may not occur even if pulses overlap, and this may be due to a voltage drop in the channel layer resulting from the three-terminal structure.

### (Prior Art Document)

### (Patent Document)

Korean Patent Application Publication No. 10-2022-0116735 (published on August 23, 2022)

### (Non Patent Document)

Li Yiyang ET AL: "In situ Parallel Training of Analog Neural Network Using Elctrochemical Random-Access Memory", FRONTIERS IN NEUROSCIENCE, vol. 15, 1 January 2021.

### SUMMARY

In view of the above, the present disclosure provides provide a three-terminal synaptic device for artificial neural network learning that configures a cross-point array based on a synaptic device with a three-terminal structure comprised of an electrochemical memory (ECRAM) and two transistors, and that can improve the accuracy of inference and learning operations occurring in the artificial neural network through parallel operation, a synaptic array using the same, and a method of operating the same.

In accordance with one embodiment of the present disclosure, there is provided a three-terminal synaptic device for artificial neural network learning, which comprises: a first transistor; an electrochemical memory (ECRAM) connected in a parallel structure with the first transistor; and a second transistor connected in series to the parallel structure.

Each of the first and second transistors may be implemented as an n-type or p-type transistor based on an oxide semiconductor.

The electrochemical memory may include: a channel region; a drain region and a source region formed on top of the channel region to be spaced apart from each other; a gate stack formed between the drain region and the source region and composed of an electrolyte layer, a reservoir layer, and a gate layer.

In accordance with another embodiment of the present disclosure, there is provided an operation method of a three-terminal synaptic device for artificial neural network learning which includes a first transistor, an electrochemical memory connected in a parallel structure with the first transistor, and a second transistor connected in series to the parallel structure, the operation method comprising: controlling an operating state of the first transistor; controlling an operating state of the second transistor; and measuring a conductivity value of the electrochemical memory in a first operating state of the first transistor and a second operating state of the second transistor.

The measuring of the conductivity value may include measuring the conductivity value from a source electrode of the electrochemical memory by applying an input voltage to a drain electrode of the second transistor in an OFF state of the first transistor and an ON state of the second transistor.

The measuring of the conductivity value may include measuring the conductivity value from a drain electrode of the second transistor by applying a delta voltage to a source electrode of the electrochemical memory in an OFF state of the first transistor and an ON state of the second transistor.

The measuring of the conductivity value may include applying stochastic voltage pulses of opposite polarities to a gate electrode and a source electrode of the electrochemical memory in an ON state of the first transistor and an OFF state of the second transistor, respectively, to change conductance of a channel region of the electrochemical memory.

In accordance with still another embodiment of the present disclosure, there is provided a synaptic array based on a three-terminal synaptic device for artificial neural network learning. The synaptic array comprises: a first line disposed in a first direction; a second line disposed in a second direction perpendicular to the first direction; and a plurality of three-terminal synaptic devices each of which is disposed in a region where the first line and the second line intersect and includes a first electrode connected to the first line, a second electrode connected to the second line, and a third electrode connected to a third line, wherein each of the plurality of three-terminal synaptic devices includes: a first transistor including the first electrode as a source electrode; an electrochemical memory (ECRAM) connected in a parallel structure with the first transistor; and a second transistor connected in series to the parallel structure and including the second electrode as a drain electrode.

In accordance with still another embodiment of the present disclosure, there is provided an operation method of a synaptic array based on a three-terminal synaptic device for artificial neural network learning, the synaptic array including a plurality of three-terminal synaptic devices each of which is disposed in a region where a first line and a second line perpendicularly intersect and includes a first transistor and an electrochemical memory forming a parallel structure, and a second transistor connected in series to the parallel structure, the method comprising: simultaneously controlling an operating state of the first transistor of each of the plurality of three-terminal synaptic devices; simultaneously controlling an operating state of the second transistor of each of the plurality of three-terminal synaptic devices; and simultaneously measuring a conductivity value of the electrochemical memory of each of the plurality of three-terminal synaptic devices in a first operating state of the first transistor and a second operating state of the second transistor.

The simultaneously controlling of the operating state of the first or second transistor may include, for each of the plurality of three-terminal synaptic devices, simultaneously controlling the first operating state or the second operating state by applying a specific voltage to a third line independently connected to a gate electrode of the first or second transistor.

The measuring of the conductivity value may include, for each of the plurality of three-terminal synaptic devices, measuring the conductivity value from the first line connected to a source electrode of the electrochemical memory by applying an input voltage to the second line connected to a drain electrode of the second transistor in an OFF state of the first transistor and an ON state of the second transistor.

The measuring of the conductivity value may include, for each of the plurality of three-terminal synaptic devices, measuring the conductivity value from the second line connected to a drain electrode of the second transistor by applying a delta voltage to a source electrode of the electrochemical memory in an OFF state of the first transistor and an ON state of the second transistor.

The measuring of the conductivity value may include, for each of the plurality of three-terminal synaptic devices, applying stochastic voltage pulses of opposite polarities to a gate electrode and a source electrode of the electrochemical memory in an ON state of the first transistor and an OFF state of the second transistor, respectively, to change conductance of a channel region of the electrochemical memory.

The technology of the present disclosure can have the following effects. However, it does not mean that a specific embodiment should include all of the following effects or only the following effects, and the scope of the present disclosure should not be understood as being limited thereby.

The three-terminal synaptic device for artificial neural network learning, the synaptic array using the same, and the method of operating the same, according to one embodiment of the present disclosure, can provide improved accuracy in inference and learning operations in the artificial neural network through parallel operation by configuring the point array based on the synaptic device with the three-terminal structure comprised of the electrochemical memory and two transistors.

### BRIEF DESCRIPTION OF THE DRAWINGS

FIG. 1 is a diagram illustrating the structure of an artificial neural network according to one embodiment of the present disclosure.
FIG. 2 is a diagram illustrating a synaptic device according to the present disclosure.
FIGS. 3 to 5 are diagrams illustrating operation methods according to various embodiments of synaptic devices among various operation processes of the artificial neural network.
FIGS. 6 to 8 are diagrams illustrating operation methods according to various embodiments of a synaptic array among various operation processes of the artificial neural network.
FIG. 9 is a flowchart illustrating the operation method of the synaptic array for artificial neural network learning according to the present disclosure.

### DETAILED DESCRIPTION

Meaning of terms described in the present application should be understood as follows.

The terms "first," "second," and the like are used to differentiate a certain component from other components, but the scope of should not be construed to be limited by the terms. For example, a first component may be referred to as a second component, and similarly, the second component may be referred to as the first component.

It should be understood that, when it is described that a component is "connected to" another component, the component may be directly connected to another component or a third component may be present therebetween. In contrast, it should be understood that, when it is described that an element is "directly connected to" another element, it is understood that no element is present between the element and another element. Meanwhile, other expressions describing the relationship of the components, that is, expressions such as "between" and "directly between" or "adjacent to" and "directly adjacent to" should be similarly interpreted.

It is to be understood that the singular expression encompasses a plurality of expressions unless the context clearly dictates otherwise and it should be understood that term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

In each step, reference numerals (e.g., a, b, c, etc.) are used for convenience of description, the reference numerals are not used to describe the order of the steps and unless otherwise stated, it may occur differently from the order specified. That is, the respective steps may be performed similarly to the specified order, performed substantially simultaneously, and performed in an opposite order.

The present disclosure can be implemented as a computer-readable code on a computer-readable recording medium and the computer-readable recording medium includes all types of recording devices for storing data that can be read by a computer system. Examples of the computer readable recording medium may include a ROM, a RAM, a CD-ROM, a magnetic tape, a floppy disk, an optical data storage device, and the like. Further, the computer readable recording media may be stored and executed as codes which may be distributed in the computer system connected through a network and read by a computer in a distribution method.

If it is not contrarily defined, all terms used herein have the same meanings as those generally understood by those skilled in the art. Terms which are defined in a generally used dictionary should be interpreted to have the same meanings as the meanings in the context of the related art, and are not interpreted as ideal meanings or excessively formal meanings unless clearly defined in the present application.

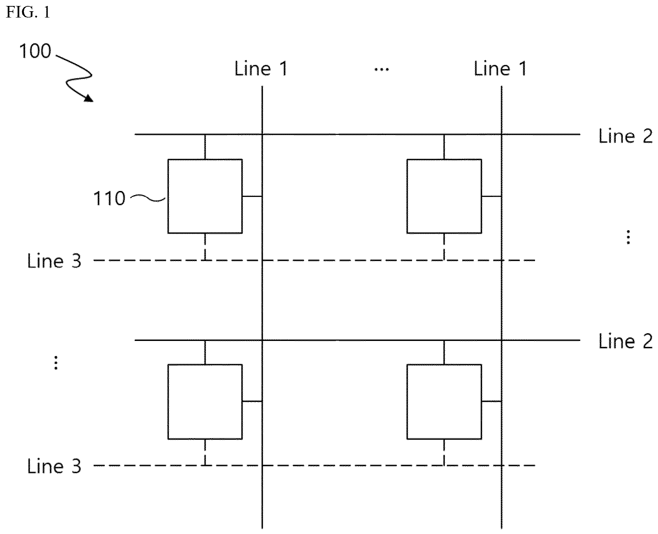

FIG. 1 is a diagram illustrating the structure of an artificial neural network according to one embodiment of the present disclosure.

Referring to FIG. 1, a synaptic array 100 implementing an artificial neural network may be formed in a structure in which a synaptic device 110 according to the present disclosure is disposed at a cross-point of a first line Line 1 and the second line Line 2, which are connected to an input and an output of the artificial neural network, respectively. For example, the first line may correspond to a word line arranged in a vertical direction, and the second line may correspond to a bit line arranged in a horizontal direction.

In addition, a plurality of first and second lines may intersect each other perpendicularly, and as a result of the synaptic devices 110 being disposed in each intersection region, a cross-point array structure of n×n size may be formed. That is, the synaptic device 110 according to the present disclosure may correspond to one cell constituting the cross-point array, and may be composed of one electrochemical memory (ECRAM, Electrochemical Random-Access Memory) and two transistors. Further, the synaptic device 110 may be implemented as a three-terminal structure, and each electrode may be connected to the first line, the second line, and a third line Line 3, respectively.

The synaptic array 100 may be connected to each synaptic device 110 through the first to third lines, which may enable parallel processing, such as simultaneously controlling the operating state of the transistors of each synaptic device 110 or simultaneously measuring the conductivity value of the electrochemical memory. For example, the operation method of the synaptic array 100 may be performed by operating a series-connected transistor to perform a vector matrix operation corresponding to the inference and error calculation process of artificial neural network learning, and then measuring a current flowing through a resistance of each synaptic device 110.

That is, for the learning process, voltage pulses can be applied to a gate terminal and a source terminal in the same manner as the existing half-bias scheme after controlling the operation of the parallel-connected transistors in the synaptic device 110. Accordingly, as a result of a uniform programming voltage being connected to the gate stack of the synaptic device 110, the traditional problem of update degradation due to voltage drop can be overcome. In particular, when an oxide semiconductor-based transistor is applied as the transistor in the synaptic device 110, the performance of the operation method according to the present disclosure can be maximized.

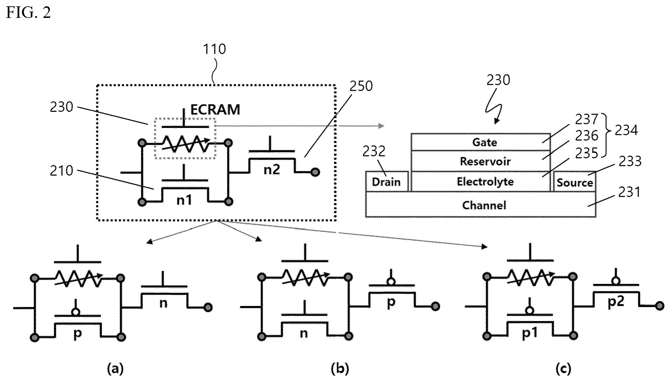

FIG. 2 is a diagram illustrating the synaptic device according to the present disclosure.

Referring to FIG. 2, the synaptic device 110 may include a first transistor 210, an electrochemical memory (ECRAM) 230, and a second transistor 250, and one unit may be configured as 2T1E. That is, the synaptic device 110 may correspond to a unit structure constituting the cross-point array according to the present disclosure.

The first transistor 210 may be connected in a parallel structure with the electrochemical memory 230. In addition, the first transistor 210 may be implemented as an oxide semiconductor-based transistor, and may be implemented as an n-type or p-type transistor.

The electrochemical memory (ECRAM) 230 may be connected in a parallel structure with the first transistor 210. Further, the electrochemical memory 230 may include a channel region 231, a drain region 232, a source region 233, and a gate stack 234.

The channel region 231 may form a channel layer on a semiconductor substrate and may be implemented with a material whose conductivity changes due to active ions. For example, the channel region 231 may be implemented with any one of materials formed of an organic semiconductor, an inorganic semiconductor, an oxide semiconductor, or the like, or a metal material, and may have the characteristic of changing conductance by active ions. The drain region 232 and the source region 233 may each be formed on top of the channel region 231 and may be formed to be spaced apart from each other. In addition, the gate stack 234 may be formed on top of the channel region 231 and may be disposed in a space between the drain region 232 and the source region 233.

In one embodiment, unlike shown in FIG. 2, the gate stack 234 may be coupled between the drain region 232 and the source region 233 to form a region overlapping with a portion of each of the drain region 232 and the source region 233. In this case, the gate stack 234 may be formed in a structure that covers the channel region 231 exposed between the drain region 232 and the source region 233. Meanwhile, the gate stack 234 is not necessarily limited to the above, and as a matter of course, may be combined in various forms between the drain region 232 and the source region 233 coupled to the top of the channel region 231.

Specifically, the gate stack 234 may be composed of an electrolyte layer 235, a reservoir layer 236, and a gate layer 237, and formed in a structure in which each layer is sequentially stacked. The electrolyte layer 235 may include an electrolyte material for ion transport between the storage layer 236 and the channel region 231. The storage layer 236 may correspond to an ion storage layer and may include an ionic material. For example, the storage layer 236 may include cations such as H⁺, Li⁺, Na⁺, or anions such as O₂⁻ as active ions.

In addition, the gate layer 238 may form a gate electrode including a barrier metal film and a metal film. When a voltage or current is applied to the gate electrode from an external source, the conductivity value of the channel region 231 may change as a result of the migration of active ions between the storage layer 236 and the channel region 231 by the applied signal.

The second transistor 250 may be connected in series to the parallel structure between the first transistor 210 and the electrochemical memory 230. Further, the second transistor 250 may be implemented as a transistor based on an oxide semiconductor, similar to the first transistor 210, and may be implemented as an n-type or p-type transistor. For example, in the case of (a) in FIG. 2, the first transistor 210 corresponds to p-type and the second transistor 250 corresponds to n-type. In the case of (b) in FIG. 2, the first transistor 210 corresponds to n-type and the second transistor 250 corresponds to p-type. In the case of (c) in FIG. 2, both the first transistor 210 and the second transistor 250 correspond to p-type.

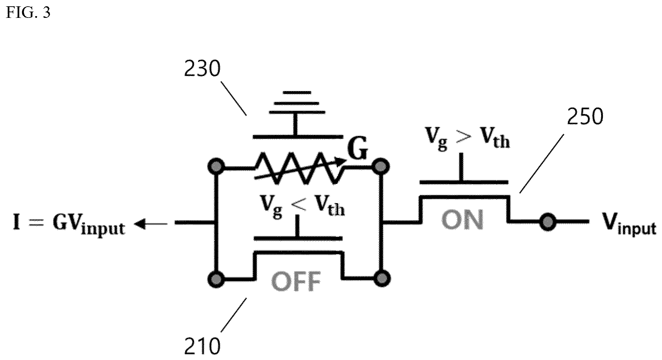

FIGS. 3 to 5 are diagrams illustrating operation methods according to various embodiments of synaptic devices among various operation processes of the artificial neural network.

FIG. 3 illustrates a method of operating the 2T1E unit synaptic device 110 in the synaptic array 100 to perform a vector matrix operation corresponding to an inference process during the operation of the artificial neural network. Specifically, the conductivity value of the ECRAM device 230 can be calculated by applying an input voltage Vᵢₙₚᵤₜ to the drain electrode of the second transistor 250 and then measuring a current (I = GVᵢₙₚᵤₜ) from the source electrode of the first transistor 210 in a state in which the operating state of the first transistor 210 is OFF, and the operating state of the second transistor 250 is ON.

Meanwhile, the operating states of the first transistor 210 and the second transistor 250 can be controlled by applying a specific voltage V_{g} to the gate electrode of each transistor. For example, in the case of an n-type transistor, in FIG. 3, when a voltage smaller than a threshold voltage Vₜₕ (i.e., V_{g} < Vₜₕ) is applied to the gate electrode of the first transistor 210, the operating state of the first transistor 210 can be switched to the OFF state. In addition, when a voltage greater than the threshold voltage Vₜₕ (i.e., V_{g} > Vₜₕ) is applied to the gate electrode of the second transistor 250, the operating state of the second transistor 250 can be switched to the ON state.

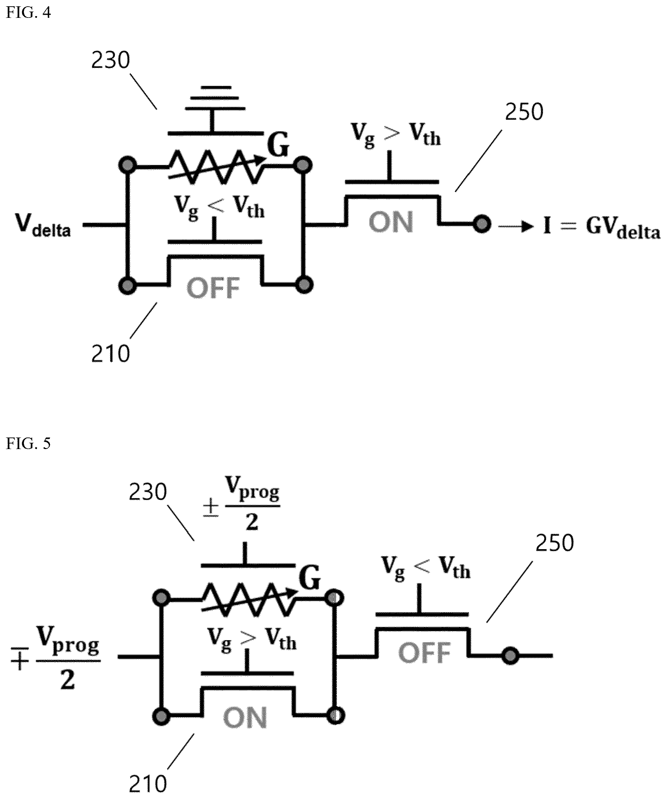

FIG. 4 illustrates a method of operating the 2T1E unit synaptic device 110 in the synaptic array 100 to perform a vector matrix operation corresponding to an error calculation process during the operation of the artificial neural network. Specifically, the conductivity value of the ECRAM device 230 can be calculated by applying a delta voltage V_{delta} to the source electrode of the ECRAM device 230 and then measuring a current (I = GV_{delta}) from the drain electrode of the second transistor 250 in a state in which the operating state of the first transistor 210 is OFF, and the operating state of the second transistor 250 is ON.

FIG. 5 illustrates a method of operating the 2T1E unit synaptic device 110 in the synaptic array 100 to perform an external operation corresponding to a weight update process during the operation of the artificial neural network. Specifically, by applying stochastic voltage pulses of opposite polarities to the gate electrode and the source electrode of the ECRAM device 230, respectively, in a state in which the operating state of the first transistor 210 is ON and the operating state of the second transistor 250 is OFF, the conductance of the channel region 231 can be changed and updated as a result.

In this case, as a result of a voltage equal to V_{prog} applied to the gate stack 234 of the ECRAM device 230, the conventional problem of update degradation due to the voltage drop can be solved. In addition, when an oxide semiconductor-based transistor is applied to the synaptic device 110, leakage current is reduced compared to a conventional MOSFET, thereby maximizing the performance of the operation method according to the present disclosure.

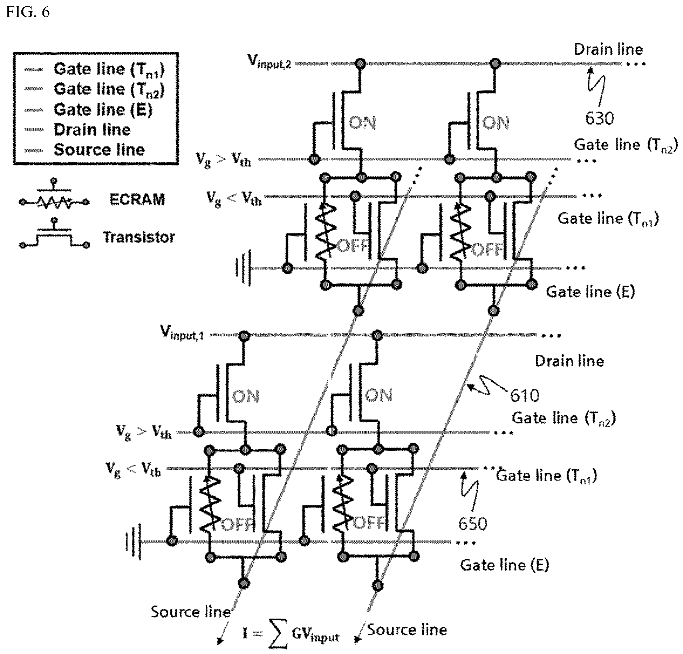

FIGS. 6 to 8 are diagrams illustrating operation methods according to various embodiments of the synaptic array among various operation processes of the artificial neural network.

Referring to FIGS. 6 to 8, the synaptic array 100 may include a first line 610 arranged in the vertical direction, a second line 630 arranged in the horizontal direction, and a synaptic device 110 disposed in an intersection region between the first line 610 and the second line 630. That is, the synaptic device 110 disposed in each intersection region may be implemented as a three-terminal analog device including first to third electrodes, wherein the first electrode is connected to the first line 610, the second electrode is connected to the second line 630, and the third electrode is connected to a third line 650.

For example, the first line may correspond to a source line connected to the source electrode of the first transistor 210 of each synaptic device 110, and the second line may correspond to a drain line connected to the drain electrode of the second transistor 250 of each synaptic device 110. In addition, the third line may correspond to a gate line connected to each gate electrode of the first transistor 210, the electrochemical memory 230, and the second transistor 250 of each synaptic device 110. In this case, the gate line may be formed independently for each gate and may be composed of a gate line (Tₙ₁), a gate line (Tₙ₂), and a gate line (E).

The synaptic array 100 according to the present disclosure may be implemented in an n×n-sized cross-point array structure based on a 2T1E unit neuromorphic device, and may perform an operation method for performing vector matrix operations of the artificial neural network by utilizing the cross-point array structure. That is, the synaptic array 100 can perform inference and learning operations occurring in the artificial neural network by applying an appropriate voltage to drive each device to the metal line in the synaptic array 100 of the cross-point array structure.

FIG. 6 illustrates an operation method for performing a vector matrix operation corresponding to the inference process of the artificial neural network in the synaptic array 100. First, the operating state of each transistor can be controlled simultaneously through the gate line 650 connected to each gate electrode of the first transistor 210 and the second transistor 250. In this case, the operating state of the first transistor 210 may be controlled to be in the OFF state, and the operating state of the second transistor 250 may be controlled to be in the ON state. In addition, the conductivity value of each ECRAM device 230 can be calculated by applying an input voltage V_{input,2} through the drain line 630 connected to each drain electrode of the second transistor 250, and then measuring a total current (I = ∑GVᵢₙₚᵤₜ) through the source line 610 connected to each source electrode of the first transistor 210.

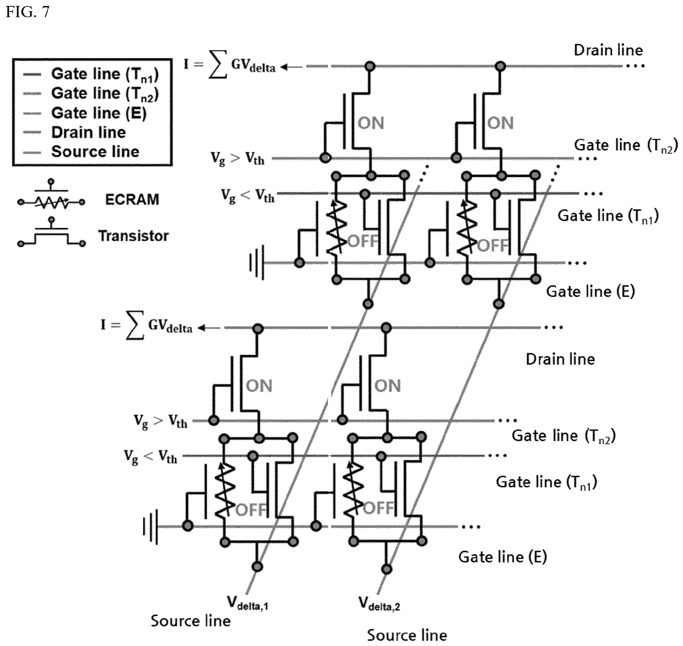

FIG. 7 illustrates an operation method for performing a vector matrix operation corresponding to the error calculation process of the artificial neural network in the synaptic array 100. In this case, the operating state of the first transistor 210 may be controlled to be in the OFF state, and the operating state of the second transistor 250 may be controlled to be in the ON state. In addition, the conductivity value of each ECRAM device 230 can be calculated by applying a delta voltage V_{delta,1} through the source line 610 connected to each source electrode of the electrochemical memory 230, and then measuring a total current (I = ΣGV_{delta}) through the drain line 630 connected to each drain electrode of the second transistor 250.

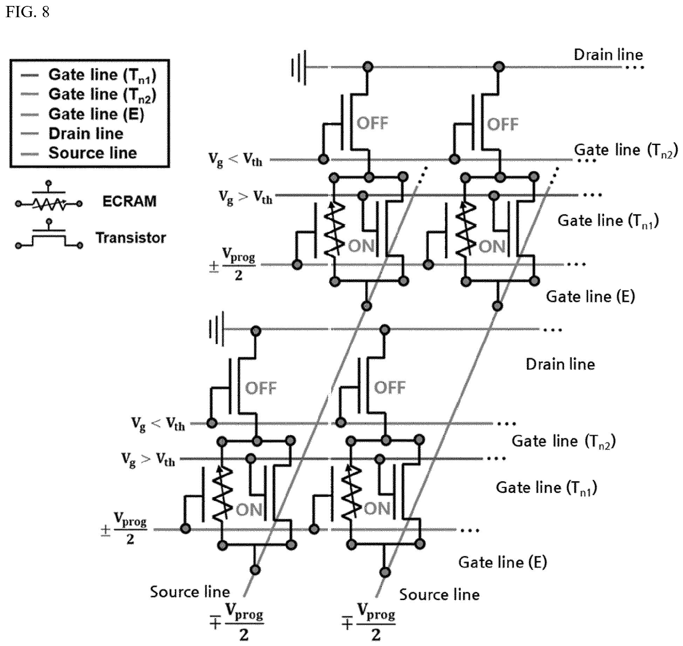

FIG. 8 illustrates an operation method for performing an external operation corresponding to the weight update process of the artificial neural network in the synaptic array 100. In this case, the operating state of the first transistor 210 may be controlled to be in the ON state, and the operating state of the second transistor 250 may be controlled to be in the OFF state. In addition, by applying stochastic voltage pulses of opposite polarities through the gate line and source line connected to each gate electrode and each source electrode of the electrochemical memory 230, the conductance of the channel region 231 in the ECRAM device 230 can be changed, resulting in an update of the weight. For example, when a voltage of -V_{prog/2} is applied to the gate electrode of the ECRAM device 230 and a voltage of +V_{prog/2} is applied to the source electrode, a voltage equal to V_{prog} can be applied to the gate stack 234 of the ECRAM device 230.

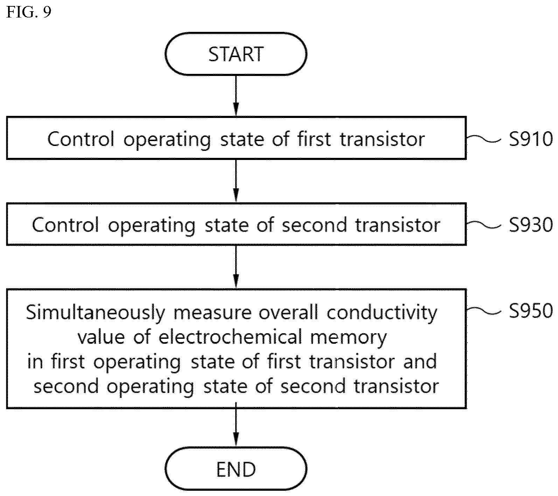

FIG. 9 is a flowchart illustrating the operation method of the synaptic array for artificial neural network learning according to the present disclosure.

Referring to FIG. 9, the synaptic device 110 according to the present disclosure may be implemented as a three-terminal analog device of 2T1E unit in which inference and learning processes in the artificial neural network can be performed by connecting a structure in which ECRAM and a transistor are connected in parallel to a transistor in series. In addition, the synaptic array 100 according to the present disclosure can be implemented as a cross-point array structure based on a three-terminal synaptic device of 2T1E unit, which can overcome the performance degradation due to voltage drop when applying a half-bias scheme.

Specifically, the operation method of the synaptic array 100 may simultaneously control the operating state of the first transistor through the gate line connected to each first transistor (Step S910), and simultaneously control the operating state of the second transistor through the gate line connected to each second transistor (Step S930).

Thereafter, the overall conductivity value of the electrochemical memory (ECRAM) may be measured simultaneously through the source line or drain line connected to each synaptic device 110 in a first operating state of the first transistor and a second operating state of the second transistor (Step S950), and based on this, the individual conductivity value of each electrochemical memory may be calculated.

The synaptic array 100 according to the present disclosure can implement a hardware cross-point array that mimics an artificial neural network using the synaptic device 110 of a three-terminal structure, and can achieve excellent learning accuracy by applying a parallel operation method to the cross-point array to perform inference and learning operations of the artificial neural network.

### (Description of Reference Numerals)

| | | | |
|---|---|---|---|
| 100: | synaptic array | 110: | synaptic device |
| 210: | first transistor | | |
| 230: | electrochemical memory, ECRAM device | | |
| 231: | channel region | 232: | drain region |
| 233: | source region | 234: | gate stack |
| 235: | electrolyte layer | 236: | reservoir layer |
| 237: | gate layer | 250: | second transistor |
| 610: | first line, source line | 630: | second line, a drain line |
| 650: | third line, gate line | | |

## Claims

1. A three-terminal synaptic device (110) for artificial neural network learning, comprising:
a first transistor (210);
an electrochemical memory (ECRAM) connected in a parallel structure with the first transistor (210); and
a second transistor (250) connected in series to the parallel structure.

2. The three-terminal synaptic device (110) of claim 1, wherein each of the first and second transistors (210, 250) is implemented as an n-type or p-type transistor based on an oxide semiconductor.

3. The three-terminal synaptic device (110) of claim 1, wherein the electrochemical memory (ECRAM) includes:
a channel region (231);
a drain region (232) and a source region (233) formed on top of the channel region (231) to be spaced apart from each other;
a gate stack (234) formed between the drain region (232) and the source region (233) and composed of an electrolyte layer (235), a reservoir layer (236) , and a gate layer (237).

4. An operation method of a three-terminal synaptic device (110) for artificial neural network learning which includes a first transistor (210), an electrochemical memory (ECRAM) connected in a parallel structure with the first transistor (210), and a second transistor (250) connected in series to the parallel structure, the method comprising:
controlling (S910) an operating state of the first transistor;
controlling (S930) an operating state of the second transistor; and
measuring (S950) a conductivity value of the electrochemical memory in a first operating state of the first transistor and a second operating state of the second transistor.

5. The method of claim 4, wherein the measuring of the conductivity value includes:
measuring the conductivity value from a source (233) electrode of the electrochemical memory (ECRAM) by applying an input voltage to a drain electrode of the second transistor (250) in an OFF state of the first transistor (210) and an ON state of the second transistor (250).

6. The method of claim 4, wherein the measuring of the conductivity value includes:
measuring the conductivity value from a drain electrode of the second transistor (250) by applying a delta voltage to a source (233) electrode of the electrochemical memory (ECRAM) in an OFF state of the first transistor (210) and an ON state of the second transistor (250).

7. The method of claim 4, wherein the measuring of the conductivity value includes:
applying stochastic voltage pulses of opposite polarities to a gate electrode and a source electrode of the electrochemical memory in an ON state of the first transistor (210) and an OFF state of the second transistor (250), respectively, to change conductance of a channel region (231) of the electrochemical memory (ECRAM).

## Patentansprüche

1. Dreipolige synaptische Vorrichtung (110) für das Lernen künstlicher neuronaler Netzwerke, umfassend:
einen ersten Transistor (210);
einen elektrochemischen Speicher (ECRAM), der mit dem ersten Transistor (210) in einer parallelen Struktur verbunden ist; und
einen zweiten Transistor (250), der mit der parallelen Struktur in Reihe verbunden ist.

2. Dreipolige synaptische Vorrichtung (110) nach Anspruch 1, wobei der erste und der zweite Transistor (210, 250) jeweils als n-Typ- oder p-Typ-Transistor auf der Basis eines Oxidhalbleiters ausgeführt sind.

3. Dreipolige synaptische Vorrichtung (110) nach Anspruch 1, wobei der elektrochemische Speicher (ECRAM) Folgendes enthält:
einen Kanalbereich (231);
einen Drain-Bereich (232) und einen Source-Bereich (233), die auf der Oberseite des Kanalbereichs (231) ausgebildet sind, um voneinander beabstandet zu sein;
einen Gate-Stapel (234), der zwischen dem Drain-Bereich (232) und dem Source-Bereich (233) ausgebildet ist und aus einer Elektrolytschicht (235), einer Reservoirschicht (236) und einer Gate-Schicht (237) besteht.

4. Betriebsverfahren einer dreipoligen synaptischen Vorrichtung (110) für das Lernen künstlicher neuronaler Netzwerke, die einen ersten Transistor (210), einen elektrochemischen Speicher (ECRAM), der mit dem ersten Transistor (210) in einer parallelen Struktur verbunden ist, und einen zweiten Transistor (250), der mit der parallelen Struktur in Reihe verbunden ist, enthält, wobei das Verfahren Folgendes umfasst:
Steuern (S910) eines Betriebszustands des ersten Transistors;
Steuern (S930) eines Betriebszustands des zweiten Transistors; und
Messen (S950) eines Leitfähigkeitswerts des elektrochemischen Speichers in einem ersten Betriebszustand des ersten Transistors und einem zweiten Betriebszustand des zweiten Transistors.

5. Verfahren nach Anspruch 4, wobei das Messen des Leitfähigkeitswerts Folgendes enthält:
Messen des Leitfähigkeitswerts von einer Source(233)-Elektrode des elektrochemischen Speichers (ECRAM), indem eine Eingangsspannung an die Drain-Elektrode des zweiten Transistors (250) in einem AUS-Zustand des ersten Transistors (210) und einem EIN-Zustand des zweiten Transistors (250) angelegt wird.

6. Verfahren nach Anspruch 4, wobei das Messen des Leitfähigkeitswerts Folgendes enthält:
Messen des Leitfähigkeitswerts von einer Drain-Elektrode des zweiten Transistors (250), indem eine Delta-Spannung an eine Source(233)-Elektrode des elektrochemischen Speichers (ECRAM) in einem AUS-Zustand des ersten Transistors (210) und einem EIN-Zustand des zweiten Transistors (250) angelegt wird.

7. Verfahren nach Anspruch 4, wobei das Messen des Leitfähigkeitswerts Folgendes enthält:
Anlegen stochastischer Spannungsimpulse entgegengesetzter Polaritäten an eine Gate-Elektrode und eine Source-Elektrode des elektrochemischen Speichers in einem EIN-Zustand des ersten Transistors (210) bzw. einem AUS-Zustand des zweiten Transistors (250), um die Leitfähigkeit eines Kanalbereichs (231) des elektrochemischen Speichers (ECRAM) zu ändern.

## Revendications

1. Dispositif synaptique à trois bornes (110) pour l'apprentissage de réseau neuronal artificiel, comprenant :
un premier transistor (210) ;
une mémoire électrochimique (ECRAM) reliée dans une structure parallèle avec le premier transistor (210) ; et
un second transistor (250) relié en série à la structure parallèle.

2. Dispositif synaptique à trois bornes (110) selon la revendication 1, dans lequel chacun des premier et second transistors (210, 250) est mis en œuvre en tant que transistor de type n ou de type p sur la base d'un semi-conducteur à oxyde.

3. Dispositif synaptique à trois bornes (110) selon la revendication 1, dans lequel la mémoire électrochimique (ECRAM) comprend :
une région de canal (231) ;
une région de drain (232) et une région de source (233) formées sur la partie supérieure de la région de canal (231) de manière à être espacées l'une de l'autre ;
un empilement de grille (234) formé entre la région de drain (232) et la région de source (233) et composé d'une couche d'électrolyte (235), d'une couche de réservoir (236) et d'une couche de grille (237).

4. Procédé de fonctionnement d'un dispositif synaptique à trois bornes (110) pour l'apprentissage de réseau neuronal artificiel qui comprend un premier transistor (210), une mémoire électrochimique (ECRAM) reliée dans une structure parallèle avec le premier transistor (210), et un second transistor (250) relié en série à la structure parallèle, le procédé comprenant :
la commande (S910) d'un état de fonctionnement du premier transistor ;
la commande (S930) d'un état de fonctionnement du second transistor ; et
la mesure (S950) d'une valeur de conductivité de la mémoire électrochimique dans un premier état de fonctionnement du premier transistor et un second état de fonctionnement du second transistor.

5. Procédé selon la revendication 4, dans lequel la mesure de la valeur de conductivité comprend :
la mesure de la valeur de conductivité à partir d'une électrode de source (233) de la mémoire électrochimique (ECRAM) en appliquant une tension d'entrée à une électrode de drain du second transistor (250) dans un état d'arrêt du premier transistor (210) et un état de marche du second transistor (250).

6. Procédé selon la revendication 4, dans lequel la mesure de la valeur de conductivité comprend :
la mesure de la valeur de conductivité à partir d'une électrode de drain du second transistor (250) en appliquant une différence de tension à une électrode de source (233) de la mémoire électrochimique (ECRAM) dans un état d'arrêt du premier transistor (210) et un état de marche du second transistor (250).

7. Procédé selon la revendication 4, dans lequel la mesure de la valeur de conductivité comprend :
l'application d'impulsions de tension stochastiques de polarités opposées à une électrode de grille et à une électrode de source de la mémoire électrochimique dans un état de marche du premier transistor (210) et un état d'arrêt du second transistor (250), respectivement, afin de modifier la conductance d'une région de canal (231) de la mémoire électrochimique (ECRAM).
